# EUROPEAN PATENT APPLICATION

(11) **EP 4 819 143 A1**
(43) Date of publication of application: **07.10.2026**
(21) Application number: 25706617.5
(22) Date of filing: 12.02.2025
(51) Int. Cl.: G11C 16/06, G11C 16/00, G11C 7/00, G11C 16/04, G11C 11/56

(54) **MEMORY DEVICE AND OPERATION METHOD THEREFOR, AND MEMORY SYSTEM**

(71) Applicant: Yangtze Memory Technologies Co., Ltd., Wuhan, Hubei 430000 (CN)
(72) Inventor: ZHUANG, Zhiwei, Wuhan, Hubei 430000 (CN); WAN, Weijun, Wuhan, Hubei 430000 (CN); DONG, Zhipeng, Wuhan, Hubei 430000 (CN); YANG, Biao, Wuhan, Hubei 430000 (CN)
(74) Representative: Lippert Stachow Patentanwälte Rechtsanwälte
(86) International application number: PCT/CN2025/077067
(87) International publication number: WO 2026/170375

(57) **Abstract**

The present disclosure provides a memory device, an operating method thereof, and a memory system. The memory device includes a memory cell array, the memory cell array includes a plurality of memory cells, each memory cell is in one of Q * 2^{K} states, Q is the number of the state groups, and each of the state groups includes 2^{K} states, wherein a plurality of state combinations formed by the states of the two memory cells are used for storing a plurality of bits of data, one of the two memory cells is in an intermediate state group in Q state groups, the other one is in one of the rest of the number of state groups excluding the intermediate state group, or the two memory cells are in the rest of the number of state groups, the rest of the number of state groups are located on two sides of the intermediate state group, and Q and K are both integers.

## Description

### TECHNICAL FIELD

The present disclosure relates to the field of semiconductor technologies, and in particular, to a memory device, an operating method thereof, and a memory system.

### BACKGROUND

Since the introduction of NAND memory, whether in the 2D or 3D era, the core driving force behind the development of NAND technology is to improve performance, extend lifespan, enhance reliability, increase storage density, and reduce the cost per memory cell. Increasing the storage density and reducing the cost per unit memory cell mainly depends on the capacity expansion of the NAND memory. An important way of capacity expansion is logical scaling. The logical scaling refers to raising storage density with bit scaling of memory cells. One of the urgent problems to be solved is to balance performance while performing logical scaling.

### SUMMARY

Examples of the present disclosure provide a memory device, an operating method thereof, and a memory system.

According to a first aspect, an example of the present disclosure provides a memory device, comprising:
a memory cell array comprising a plurality of memory cells, wherein each of the memory cells is in one of Q × 2^{K} states, the Q is a number of state groups, and each of the state groups comprises 2^{K} states;
wherein a plurality of state combinations formed by states of two memory cells are configured to store multiple bits of data; and one of the two memory cells is in an intermediate state group in the Q state groups, and the other is in one of the rest of the number of state groups excluding the intermediate state group, or the two memory cells are both in the rest of the number of state groups; the rest of the number of state groups are located on two sides of the intermediate state group, and Q and K are both integers.

According to a second aspect, an example of the present disclosure provides another memory device, comprising:
a memory cell array, comprising a plurality of memory cells, wherein each of the memory cells is in one of Q × 2^{K} states; wherein states of two memory cells coupled to a same word line form a plurality of state combinations for storing Q + 2K bits of data, and Q and K are both integers; and
a peripheral circuit coupled to the memory cell array; wherein when reading each bit in the Q bits of data, the peripheral circuit is configured to:
   applying a first read voltage to a selected word line; and
   after applying the first read voltage, applying a second read voltage to the selected word line.

According to a third aspect, an example of the present disclosure provides a memory system, comprising:
at least one memory device according to any one of the first aspect and the second aspect of the present disclosure; and
a memory controller coupled to the memory device and configured to control the memory device.

According to a fourth aspect, an example of the present disclosure provides an operating method of a memory device, wherein the memory device comprises a memory cell array comprising a plurality of memory cells, wherein each of the memory cells is in one of Q × 2^{K} states; wherein states of two memory cells coupled to a same word line form a plurality of state combinations for storing Q + 2K bits of data, and Q and K are both integers; and
the operating method comprises:
applying a first read voltage to a selected word line when read each bit in the Q bits of data; and after applying the first read voltage, applying a second read voltage to the selected word line.

In the examples of the present disclosure, the intermediate state group is located between of the rest of the number of state groups, and the memory cells in the intermediate state group are easier to cross the threshold voltage distribution when the threshold voltage shift occurs, and are incorrectly read into a state group that is lower or higher than the intermediate state group. That is, the read noise of the intermediate state group is larger, and the read reliability is lower relative to other state groups. In the examples of the present disclosure, the two memory cells are both in the other state group, or one of the two memory cells is in the intermediate state group and the other is in the other state group, that is, the state combination formed by the states in the intermediate state group of the two memory cells is discarded, so that the read noise of the state combination of the two memory cells can be reduced, thereby improving the reliability of data reading.

### BRIEF DESCRIPTION OF DRAWINGS

FIG. 1 is a schematic diagram of an example system according to an example of the present disclosure.
FIG. 2a is a schematic diagram of a memory card according to an example of the present disclosure.
FIG. 2b is a schematic diagram of an SSD according to an example of the present disclosure.
FIG. 3 is a schematic diagram of a memory including a peripheral circuit according to an example of the present disclosure.
FIG. 4 is a schematic diagram of a memory cell array including a NAND memory string according to an example of the present disclosure.
FIG. 5 is a schematic diagram of a change of a bit of a memory cell according to an example of the present disclosure.
FIG. 6 is a schematic diagram of a peripheral circuit according to an example of the present disclosure.
FIG. 7 is a first correspondence between state groups of two memory cells and 3 bits of data according to an example of the present disclosure.
FIG. 8 is a table of correspondence between state groups of two memory cells and 3 bits of data according to an example of the present disclosure.
FIG. 9 is a second correspondence between state groups of two memory cells and 3 bits of data according to an example of the present disclosure.
FIG. 10 is a third correspondence between state groups of two memory cells and 3 bits of data according to an example of the present disclosure.
FIG. 11 is a fourth correspondence between state groups of two memory cells and 3 bits of data according to an example of the present disclosure.
FIG. 12 is a fifth correspondence between state groups of two memory cells and 3 bits of data according to an example of the present disclosure.
FIG. 13 is a first correspondence between state codes of two memory cells and 3 bits of data according to an example of the present disclosure.
FIG. 14a to FIG. 14c are schematic diagrams of a relationship between values of bit0, bit1, and bit2 and state codes of two memory cells according to an example of the present disclosure.
FIG. 15 is a second correspondence between state codes of two memory cells and 3 bits of data according to an example of the present disclosure.
FIG. 16 and FIG. 17 are schematic diagrams of threshold voltage distributions of memory cells storing 1.5 bits of data according to an example of the present disclosure.
FIG. 18 is a schematic diagram of reliability of a state code according to an example of the present disclosure.
FIG. 19 is a schematic diagram of threshold voltage distribution of a memory cell storing 4.5 bits of data according to an example of the present disclosure.
FIG. 20 is a schematic diagram of a peripheral circuit including a page buffer according to an example of the present disclosure.
FIG. 21 is a schematic flowchart of an operating method according to an example of the present disclosure.

### DETAILED DESCRIPTION

Examples disclosed in the present disclosure will be described in more detail below with reference to the drawings. Although examples of the present disclosure are shown in the drawings, it is to be understood that the present disclosure may be implemented in various forms and should not be limited to the detailed description set forth herein. Rather, these examples are provided such that the present disclosure can be more thoroughly understood and the scope disclosed in the present disclosure can be fully conveyed to those skilled in the art.

In the following description, numerous specific details are given in order to provide a more thorough understanding of the present disclosure. It will be apparent to those skilled in the art, however, that the present disclosure may be practiced without one or more of these details. In other examples, to avoid confusion with the present disclosure, some technical features known in the art are not described. That is, not all features of the actual examples are described herein, and well-known functions and structures are not described in detail.

In the drawings, like reference numerals refer to like elements throughout.

It should be understood that spatial relation terms such as "beneath," "below," "lower," "under," "above," "upper," etc., may be used herein for ease of description to describe the relationship between one element or feature and other elements or features shown in the drawings. It should be appreciated that in addition to the orientations shown in the drawings, the spatial relation term intent to also include different orientations of the devices in use and operation. For example, if the devices in the drawings are flipped, then described as "below" or "under" or "beneath" other elements or features will be oriented "on" other elements or features. Thus, the example terms "below" and "under" may include both upper and lower orientations. The devices may be additionally oriented (rotated 90 degrees or other orientations) and the spatial description terminology used herein is interpreted accordingly.

A term used herein is just for the purpose of describing a particular example and is not to be considered as limitation of the present disclosure. As used herein, "a," "an" and "said/the" in the singular forms are intended to include the plural forms as well, unless the context clearly indicates otherwise. It should also be understood that at least one of the terms "consist of" "include", or "comprise," when used in this specification, identify the presence of at least one of stated features, integers, steps, operations, elements or components, but do not exclude the presence or addition of at least one of one or more other features, integers, steps, operations, elements, components or groups. As used herein, the term "at least one of" includes any and all combinations of the related listed items.

Increasing storage density to reduce the cost per memory cell has always been the direction and driving force of NAND memory development, and achieving increased storage density and reduced cost per memory cell mainly relies on capacity expansion of NAND memory. An important way of capacity expansion is logical scaling. The logical scaling refers to raising storage density with bit expansion of memory cells. At present, a normal logical scaling manner is to expand the bits of a single memory cell. The NAND memory sequentially experiences SLC storing 1bit data per memory cell, MLC storing 2bits data per memory cell, TLC storing 3bits data per memory cell, and QLC storing 4bits data per memory cell. Logic scaling also brings a sacrifice in performance, lifespan and the like while providing storage density, and a solution has been proposed to store X.5bits data per memory cell taking into account both storage capacity and reliability.

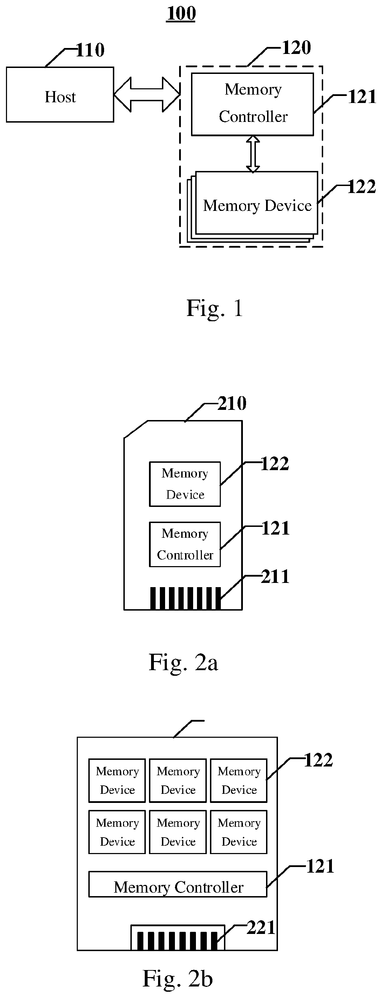

FIG. 1 is a block diagram of an example system including a memory according to an example of the present disclosure. The example system 100 may include a host 110 and a memory system 120. The example system 100 may include, but is not limited to, a mobile phone, a desktop computer, a laptop computer, a tablet computer, a vehicular computer, a game console, a printer, a positioning device, a wearable electronic device, a smart sensor, a Virtual Reality (VR) device, an Augmented Reality (AR) device, or any other suitable electronic device having a memory device 122 therein. The host 110 may be a processor (e.g., a Central Processing Unit (CPU) or a System on Chip (SoC) (e.g., an Application Process (AP)) of the electronic device.

In an example of the present disclosure, the host 110 may be configured to send data to or receive data from the memory system 120. Here, the memory system 120 may include a memory controller 121 and one or more memory devices 122. The memory device 122 may include, but is not limited to, a NAND Flash Memory, a Vertical NAND Flash Memory, a NOR Flash Memory, a Dynamic Random Access Memory (DRAM), a Ferroelectric Random Access Memory (FRAM), a Magnetoresistive Random Access Memory (MRAM), a Phase Change Random Access Memory (PCRAM), a Resistive Random Access Memory (RRAM), a Nano Random Access Memory (NRAM), or the like.

In an example of the present disclosure, a Memory Controller 121 may be coupled to the memory device 122 and the host 110 and configured to control the memory device 122. For example, the memory controller 121 may be designed to operate in a low duty cycle environment, such as a Secure Digital (SD) card, a Compact Flash (CF) card, a Universal Serial Bus (USB) flash drive, or other medium for use in electronic devices such as personal computers, digital cameras, mobile phones, and the like. In some examples, the memory controller 121 may also be designed to operate in a high duty cycle environment, such as a Solid State Disk (SSD) or an embedded Multi-Media Card (eMMC), and the SSD or eMMC may be used as a data storage for a mobile device such as a smartphone, a tablet computer, and a laptop computer, etc., and an enterprise memory array.

Further, the memory controller 121 may manage data in the memory device 122 and communicate with the host. The memory controller 121 may be configured to control operations of the memory device 122, such as read, erase, and program, may also be configured to manage various functions regarding data stored in or to be stored in the memory device 122, including, but not limited to, bad block management, garbage collection, logical-to-physical address translation, wear leveling, etc., and may also be configured to process Error Checking and Correction (ECC) regarding data read from or written into the memory device 122. Furthermore, the memory controller 121 may also perform any other suitable function, such as formatting the memory device 122, or communicating with an external device (e.g., host 110 in FIG. 1) according to a particular communication protocol. For example, the memory controller 121 may communicate with an external host over at least one of various interface protocols, such as a USB protocol, an MMC protocol, a Peripheral Component Interconnect (PCI) protocol, a Peripheral Component Interconnect Express (PCI-E) protocol, an Advanced Technology Attachment (ATA) protocol, a serial ATA protocol, a parallel ATA protocol, a Small Computer System Interface (SCSI) protocol, an Enhanced Small Disk Interface (ESDI) protocol, an Integrated Development Equipment (IDE) protocol, a Firewire protocol, or the like.

In an example of the present disclosure, the memory controller 121 and the one or more memory devices 122 may be integrated into various types of storage devices, for example, included in the same package (e.g., Universal Flash Storage (UFS) package or eMMC package). That is, the memory system 120 may be implemented and packaged into different types of terminal electronics. As shown in FIG. 2a, the memory controller 121 and the single memory device 122 may be integrated together to form the memory card 210. The memory card 210 may include a PC card (Personal Computer Memory Card International Association), a CF card, a Smart Media (SM) card, a memory stick, a multimedia card (MMC (Multi-Media Card), an RS-MMC (Reduced Size MMC), an MMCmicro), an SD card (SD, miniSD, microSD, Secure Digital High Capacity (SDHC)), UFS, and the like. The memory card 210 may also include a memory card connector 211 that couples the memory card 210 with a host (e.g., host 110 in FIG. 1). In another example as shown in FIG. 2b, the memory controller 121 and the plurality of memory devices 122 may be integrated together to form the SSD 220. SSD 220 may also include an SSD connector 221 that couples SSD 220 with a host (e.g., host 110 in FIG. 1). In some examples, the storage capacity and/or operating speed of the SSD 220 is greater than the storage capacity and/or the operating speed of the memory card 210.

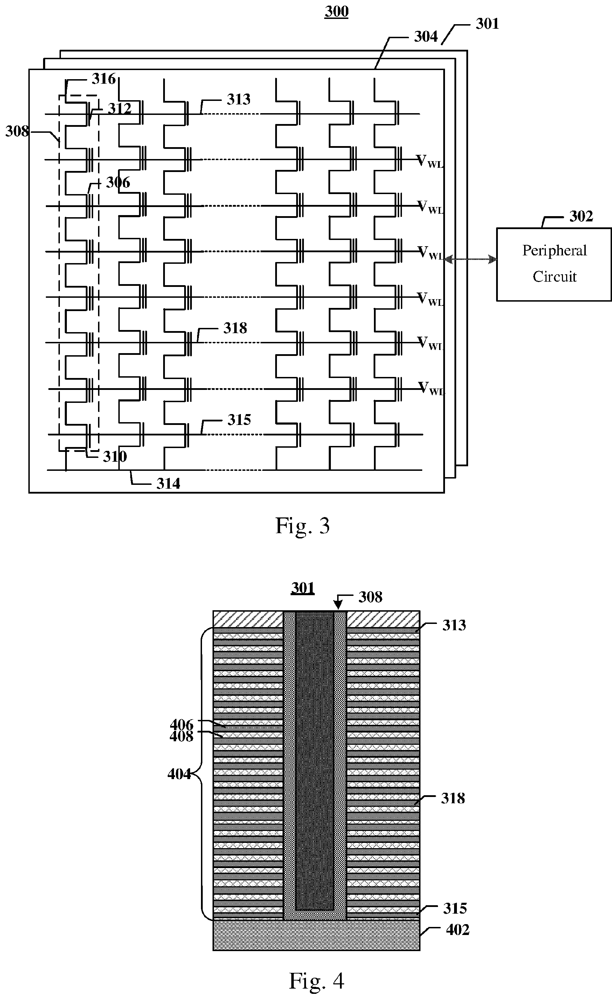

It should be noted that the memory related to an example of the present disclosure may be a semiconductor memory, which is a solid state electronic device for storing data information made by a semiconductor integrated circuit process. FIG. 3 is a schematic diagram of a memory comprising a peripheral circuit according to an example of the present disclosure, wherein the memory device 300 may be the memory device 122 in FIG. 1 to FIG. 2b. As shown in FIG. 3, the memory device 300 may include a memory cell array 301 and a peripheral circuit 302 coupled to the memory cell array 301. Here, the memory cell array may be an array of NAND flash memory cells, wherein the memory cells are disposed in the form of an array of NAND memory strings 308, and each NAND memory string 308 extends vertically above the substrate. In some examples, each NAND memory string 308 may include a plurality of memory cells 306 coupled in series and stacked vertically. Each memory cell 306 may maintain a continuous analog value, such as a voltage or charge, depending on the number of electrons captured within the memory cell region. In addition, each memory cell 306 in the above memory cell array 301 may be a floating gate type of memory cell including a floating gate transistor, or a charge trapping type of memory cell including a charge trapping transistor.

As shown in FIG. 3, each NAND memory string 308 may include a source select transistor 310 at its source terminal and a drain select transistor 312 at its drain terminal. The source select transistor may also be referred to as a lower select transistor, and the drain select transistor may also be referred to as an upper select transistor. The source select transistor 310 and the drain select transistor 312 may be configured to activate the selected NAND memory string 308 (column of the array) during read and program operations.

In some examples, the sources of the NAND memory strings 308 in a same block 304 are coupled through a same source line (SL) 314 (e.g., a common source line). In other words, according to some examples, all NAND memory strings 308 in the same block 304 have an array common source (ACS). According to some examples, the drain select transistor 312 of each NAND memory string 308 is coupled to a respective bit line 316 from which data may be read or written via an output bus (not shown).

In some examples, each NAND memory string 308 is configured to be at least one of: selected or deselected by applying a select voltage (e.g., higher than a threshold voltage with a drain select transistor 312) or a deselect voltage (e.g., 0V) to a gate of a respective drain select transistor 312 via one or more drain select gate lines (DSG lines) 313; or selected or deselected by applying a select voltage (e.g., higher than a threshold voltage with a source select transistor 310) or a deselect voltage (e.g., 0V) to a gate of a respective source select transistor 310 via one or more source select gate lines 315. The NAND memory string 308 may thus be divided into a selected NAND memory string or a non-selected NAND memory string.

As shown in FIG. 3, the NAND memory string 308 may be organized into a plurality of blocks 304, each of which may have a common source line 314 (e.g., coupled to ground). In some examples, each block 304 is a basic data unit for an erase operation, i.e., all memory cells 306 on the same block 304 are erased simultaneously. To erase the memory cells 306 in the selected block, the source lines 314 coupled to the selected block and non-selected blocks in the same plane as the selected block may be biased with erase voltages (Vers), such as a high positive voltage (e.g., 20V or higher). It should be understood that in some examples, an erase operation can be performed at a half-block level, a quarter-block level, or a level having any suitable number of blocks or fractions of a block.

Memory cells 306 of adjacent NAND memory strings 308 may be coupled by word lines 318. There are a plurality of word lines 318, and each word line 318 is coupled to a plurality of memory cells 306. When a certain word line 318 is selected, a read or program operation may be performed on the memory cell 306 coupled to the word line 318.

FIG. 4 is a schematic diagram of a memory cell array including a NAND memory string according to an example of the present disclosure. As shown in FIG. 4, a NAND memory string 308 may extend vertically through the memory stack layer 404 over the substrate 402. The substrate 402 may include silicon (e.g., monocrystalline silicon), silicon germanium (SiGe), gallium arsenide (GaAs), germanium (Ge), silicon-on-insulator (SOI), germanium-on-insulator (GOI), or any other suitable material.

The memory stack layer 404 may include alternating gate conductive layers 406 and dielectric layers 408, wherein the number of pairs of gate conductive layers 406 and dielectric layers 408 may determine the number of memory cells 306 in the memory cell array 301. The gate conductive layer 406 may include a conductive material including, but not limited to, tungsten (W), cobalt (Co), copper (Cu), aluminum (Al), polysilicon, doped silicon, silicide, or any combination thereof. In some examples, each gate conductive layer 406 includes a metal layer, such as a tungsten layer. In some examples, each gate conductive layer 406 includes a doped polysilicon layer. The gate conductive layer 406 may extend laterally at the top of the memory stack layer 404 as the drain select gate line 313, extend laterally at the bottom of the memory stack layer 404 as the source select gate line 315, or extend laterally between the drain select gate line 313 and the source select gate line 315 as the word line 318. It should be understood that although one source select gate line (SSG line) 315 and one drain select gate line (DSG line) 313 are shown in FIG. 3, the number of source select gate lines 315 and the number of drain select gate lines 313 (and the number of source select transistors 310 and drain select transistors 312 coupled to the source select gate line 315 and drain select gate line 313, respectively) may vary in other examples.

As shown in FIG. 4, the NAND memory string 308 includes a channel structure that extends vertically through the memory stack layer 404. In some examples, the channel structure includes a channel hole filled with semiconductor material (e.g., as a semiconductor channel) and dielectric material (e.g., as a memory film). In some examples, the semiconductor channel includes silicon, e.g., polysilicon. In some examples, the memory film is a composite dielectric layer including a tunneling layer, a storage layer (also referred to as a "charge trapping layer"), and a blocking layer. Channel structure may have a cylinder shape (e.g., a pillar shape). According to some examples, the semiconductor channel 420, tunneling layer, storage layer, and blocking layer are disposed radially in order from the center toward the outer surface of the pillar . The tunneling layer may include silicon oxide, silicon oxynitride, or any combination thereof. The storage layer may include silicon nitride, silicon oxynitride, or any combination thereof. The blocking layer may include silicon oxide, silicon oxynitride, a high dielectric constant (high-k) dielectric, or any combination thereof. In one example, the memory film may include a composite layer of silicon oxide/silicon oxynitride/silicon oxide (ONO). It should be understood that the structure of the channel structure depicted in FIG. 4 is just for illustrative purposes and may vary in other examples. It should be understood that although not shown in FIG. 4, additional components (including but not limited to, gate line slit/source contacts, local contacts, interconnect layers, and the like) of the memory cell array 301 may also be formed.

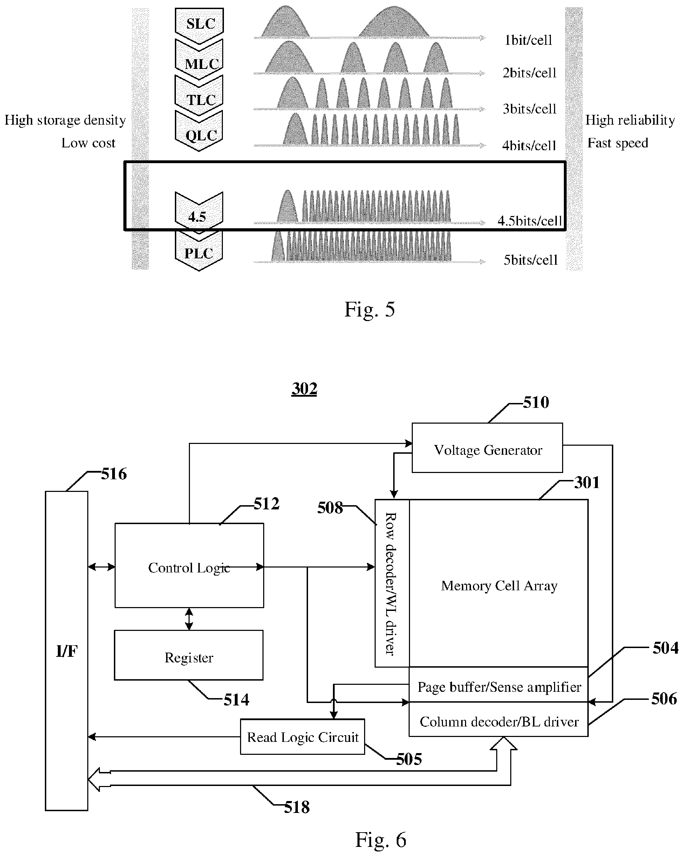

FIG. 5 is a schematic diagram of the change of bits of a memory cell according to an example of the present disclosure. In some examples, a memory cell (e.g., memory cell 306 in FIG. 3) may be a Single Level Cell (SLC), which has two possible memory states and thus may store one bit of data. For example, the first memory state "0" may correspond to a first threshold voltage distribution, and the second memory state "1" may correspond to a second threshold voltage distribution. In another example, the memory cell may be a multi-level memory cell capable of storing more than a single bit of data in more than four memory states. For example, the memory cell may store two bits of data in four memory states, referred to as a Two Level Cell or a Multi Level Cell (MLC). The memory cell may also store three bits of data in eight memory states, referred to as Triple Level Cell (TLC). The memory cell may also store four bits of data in sixteen states, referred to as Quad Level Cells (QLCs). Alternatively, the memory cell may also store five bits of data in thirty-two states, referred to as Penta Level Cell (PLC).

The division of the states of the memory cells may be understood as dividing the threshold voltages of the memory cells. Taking the MLC as an example, the threshold voltages of the memory cells may be divided into 4 intervals, corresponding to the P1 state, the P2 state, the P3 state and the P4 state, respectively. The P1 state through the P4 state are four states corresponding to the MLC in FIG. 5. As shown in FIG. 5, as the number of bits stored in the memory cell increases, the data stored in the single memory cell becomes more and more, such that the storage density is increased and the cost per memory cell is reduced. Meanwhile, as the division of the threshold voltages in one memory cell is finer, the controlling of the number of electrons entering the memory layer needs to be finer when the write operation is performed, therefore the write time is extended. Similarly, more read voltages are required to be read when reading is performed, and the read time may be extended, therefore the read speed is reduced. Moreover, as shown in FIG. 5, the read window between the threshold voltage distributions of adjacent states becomes smaller, such that the probability of errors occurring when writing the data or reading the data is increased, causing the reduced reliability of the memory cell. Therefore, in term of performance, from the PLC to the SLC, the reliability gradually deteriorates and the read/write speed gradually decreases.

A memory cell proposed in the examples of the present disclosure stores X.5bits data, for example, 1.5 bits, 2.5 bits, 3.5 bits, 4.5 bits, etc. The storage density of a single memory cell storing 1.5bits is between SLC and MLC, the storage density of a single memory cell storing 2.5bits is between MLC and TLC, the storage density of a single memory cell storing 3.5bits is between TLC and QLC, and the storage density of a single memory cell storing 4.5bits is between QLC and PLC. Taking a single memory cell storing 4.5bits data shown in FIG. 5 as an example, the memory cell may store 4.5bits data in 24 states. Compared with the PLC that needs 32 states, the read window between the 24 states is larger, so the reliability is better, and the data is read faster. Compared with a QLC, one memory cell may store more data, so the storage density is larger, and the cost is also reduced. A single memory cell storing X.5bits may achieve better balance between storage density and reliability, thereby meeting market demands.

Referring back to FIG. 3, the peripheral circuit 302 may be coupled to the memory cell array 301 through bit lines 316, word lines 318, source lines 314, source select gate lines 315, and drain select gate lines 313. The peripheral circuit 302 may include any suitable analog, digital, and mixed signal circuit for the write and read operations of the memory cell array 301 by applying at least one of voltage signal or current signal to each of the target memory cells 306 and sensing at least one of voltage signal or current signal from each of the target memory cells 306 via bit lines 316, word lines 318, source lines 314, source select gate lines 315, and drain select gate lines 313. The peripheral circuit 302 may include various types of peripheral circuit formed using metal-oxide-semiconductor (MOS) technology. For example, FIG. 6 is a schematic diagram of a peripheral circuit 302 according to an example of the present disclosure, including a page buffer/sense amplifier 504, a read logic circuit 505, a column decoder/BL driver 506, a row decoder/WL driver 508, a voltage generator 510, a control logic 512, a register 514, an interface (I/F) 516, and a data bus 518. It should be understood that in some examples, additional peripheral circuits not shown in FIG. 6 may also be included.

The page buffer/sense amplifier 504 may be configured to read data from and program (write) data to the memory cell array 301 according to control signals from the control logic 512. In one example, the page buffer/sense amplifier 504 may store program data (write data) to be programmed into memory cells of the memory cell array 301 coupled to one word line 318. In another example, the page buffer/sense amplifier 504 may perform a program verify operation to ensure that the data has been correctly programmed into the memory cells 306 coupled to the selected word line 318. In yet another example, the page buffer/sense amplifier 504 may also sense a low power signal from the bit line 316 representing a data bit stored in the memory cell 306, and amplify the small voltage swing to an identifiable logic level in a read operation.

The read logic circuit 205 may be configured to perform a logic operation on the hard read value output by the page buffer/sense amplifier 504 to obtain read data when performing read operation of X.5bits data.

The column decoder/BL driver 506 may be configured to be controlled by control logic 512 and select one or more NAND memory strings 308 by applying a bit line voltage generated from voltage generator 510.

The row decoder/WL driver 508 may be configured to be controlled by the control logic 512 and select/deselect the block 304 of the memory cell array 301 and select/deselect the word line 318 in the block 304 according to the control signal generated by the control logic. The row decoder/WL driver 508 may also be configured to drive the word lines 318 using different word line voltages generated from the voltage generator 510. In some examples, the row decoder/WL driver 508 may also select/deselect the source select gate line 315 and the drain select gate line 313. The row decoder/WL driver 508 is configured to at least one of: drive the source select gate line 315 using a different SSG line voltage generated from the voltage generator 510, or drive the drain select gate line 313 using a different DSG line voltage generated from the voltage generator 510.

The voltage generator 510 may be configured to be controlled by the control logic 512 and generate various word line voltages (e.g., read voltages, program voltages, pass voltages, verify voltages, etc.), bit line voltages, ground voltages, various SSG line voltages (e.g., select voltages, deselect voltages), and various DSG line voltages (e.g., select voltages, deselect voltages) to be supplied to the memory cell array 301.

Control logic 512 may be coupled to each peripheral circuit portion described above and configured to control operation of each peripheral circuit portion. Registers 514 may be coupled to control logic 512 and include status registers, command registers, and address registers, to store status information, command operation code, and command addresses for controlling operation of the peripheral circuit. In some examples, control logic 512 may receive program commands issued by a memory controller (e.g., memory controller 106 in FIG. 1) and send control signals to various peripheral circuit portions, such as row decoder/word line driver 508, column decoder/bit line driver 506, and voltage generator 510, to perform program operations on source select transistors coupled to the source select gate lines.

Interface 516 may be coupled to control logic 512 and act as a control buffer to buffer control commands (e.g., program commands) received from a memory controller or host and relay them to control logic 512, and buffer status information received from control logic 512 and relay them to a memory controller or host. The interface 516 may also be coupled to the column decoder/bit line driver 506 via a data bus 518 and act as a data input/output (I/O) interface and a data buffer to buffer data and relay them to the memory cell array 301, or buffer or relay data from the memory cell array 301.

Referring back to FIG. 5, a single memory cell stores X.5bits data by a state combination of two memory cells. The example of the present disclosure provides a program manner and a read operating method of jointly storing data by two memory cells. In some examples, the memory device includes a memory cell array, the memory cell array includes a plurality of memory cells, each of the memory cells is in one of Q × 2^{K} states, Q is the number of state groups, each of the state groups includes 2^{K} states, wherein a plurality of state combinations formed by the states of the two memory cells are configured to store multi-bit data, and one of the two memory cells is in an intermediate state group in Q state groups, and the other is in one of the rest of the number of state groups excluding the intermediate state group, or both memory cells are in the rest of the number of state groups, and the rest of the number of state groups are located on two sides of the intermediate state group, and Q and K are both integers.

The memory device in the examples may be the memory device shown in any example in FIG. 1 to FIG. 6. The memory device includes a memory cell array including a plurality of memory cells disposed in an array, and the memory cells includes NAND flash memory cells. For example, the memory cell array may include the memory cell array 301 in FIG. 3 and FIG. 6, and the memory cells may include the memory cells shown in any example in FIG. 3 through FIG. 5.

In an example of the present disclosure, each memory cell is in one of Q × 2^{K} states, wherein Q is a number of state groups, and each state group includes 2^{K} states sequentially adjacent to each other. The states of the two memory cells may form Q² × 2^{2K} state combinations, and after some unreliable state combinations are discarded, the remaining state combinations may store Q + 2K bits of data.

Two memory cells that are to collectively store data are referred to herein as a first memory cell and a second memory cell. In the Q + 2K bits of data, the Q bits of data is jointly stored by the combination formed by the state groups where the first memory cell and the second memory cell are located. It may be understood that the Q state groups of the first memory cell and the Q state groups of the second memory cell form a plurality of combinations to store the Q bits of data. Not all combinations are used to store data. Instead, unreliable combinations are discarded, and the remaining 2^{Q} combinations are used to store the Q bits of data.

The unreliable combinations discarded include a combination formed by the first memory cell being in the intermediate state group and the second memory cell being in the intermediate state group. The intermediate state group is one of the Q state groups. The Q state groups include the rest of the number of state groups in addition to the intermediate state group. The rest of the number of state groups are located on two sides of the intermediate state group, that is, the intermediate state group is not the highest state group or the lowest state group in the Q state groups, and there are other state groups on both sides of the intermediate state group.

After the unreliable combinations are discarded, the remaining combinations for storing the Q bits of data include a combination in which both the first memory cell and the second memory cell are in the rest of the state groups, a combination in which the first memory cell is in the intermediate state group and the second memory cell is in the rest of the state groups, and a combination in which the first memory cell is in the rest of the state groups and the second memory cell is in the intermediate state group. That is, both memory cells are in the rest of the number of state groups, or one of the two memory cells is in the intermediate state group, and the other is in one of the rest of the number of state groups.

For example, Q is greater than or equal to 3, for example, may be an odd number such as 3 or 7. That is, the number of state groups may be 3, 7, or the like. The odd number of state groups are numbered in ascending order of threshold voltage distributions, and the intermediate state group is a state group of the odd number of state groups residing in the middle position. For example, a second state group in the 3 state groups, and a fourth state group in the 7 state groups.

The following takes Q being 3 as an example to illustrate the combination of the state groups for storing the Q bits of data.

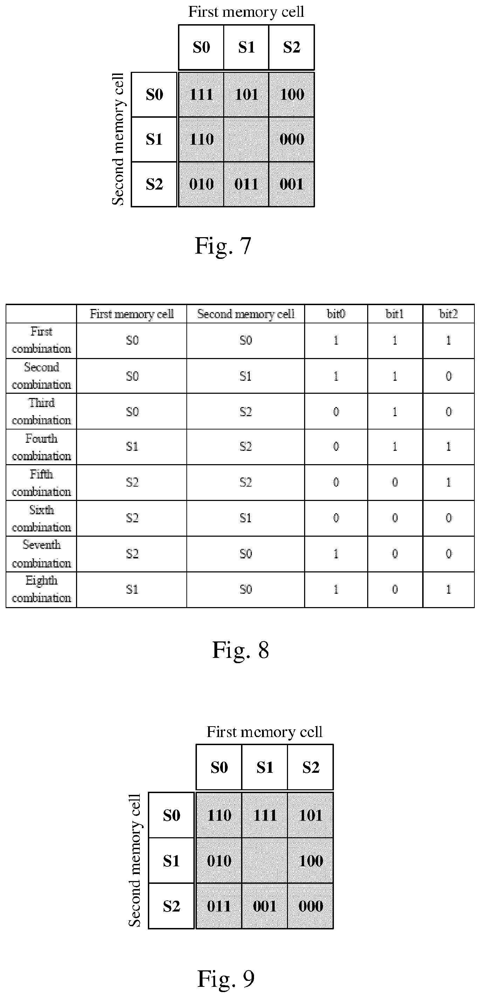

FIG. 7 shows a correspondence between a combination of state groups of two memory cells and 3 bits of data. The 3 state groups of the first memory cell are disposed horizontally on the nine-grid, the 3 state groups of the second memory cell are disposed vertically on the left side of the nine-grid, and the data in the nine-grid is the possible value of the 3 bits of data stored jointly by a combination of the state groups of the two memory cells. For example, the 3 state groups are sorted in ascending order of threshold voltages into a low state group S0, an intermediate state group S1, and a high state group S2, and the state groups of the first memory cell and the second memory cell may form 9 combinations. After the combination formed by the intermediate state group S1 of the first memory cell and the intermediate state group S1 of the second memory cell is discarded, the remaining 8 combinations may store 3 bits of data.

The 8 combinations are first combination to eighth combination respectively, wherein the first combination includes that the first memory cell is in the low state group S0 and the second memory cell is in the low state group S0, the second combination includes that the first memory cell is in the low state group S0 and the second memory cell is in the intermediate state group S1, the third combination includes that the first memory cell is in the low state group S0 and the second memory cell is in the high state group S2, the fourth combination includes that the first memory cell is in the intermediate state group S1 and the second memory cell is in the high state group S2, the fifth combination includes that the first memory cell is in the high state group S2 and the second memory cell is in the high state group S2, the sixth combination includes that the first memory cell is in the high state group S2 and the second memory cell is in the intermediate state group S1, the seventh combination includes that the first memory cell is in the high state group S2 and the second memory cell is in the low state group S0, and the eighth combination includes that the first memory cell is in the intermediate state group S1 and the second memory cell is in the low state group S0. As shown in FIG. 7, 8 combinations may correspondingly store 3 bits of data.

The threshold voltage of the memory cell may be offset by the electric field coupling of the adjacent memory cell. In addition, in the read operation, the threshold voltage of the memory cell may also be offset by the passing voltage applied to the unselected word line. However, since the threshold voltage distribution of the intermediate state group is between the threshold voltage distributions of the high state group and the low state group, the memory cell in the intermediate state group is easier to cross the threshold voltage distribution due to this threshold voltage offset, and is incorrectly read as being in a low state group or a high state group. That is, the read noise of the memory cells in the intermediate state group is larger, and the reliability of the reading is lower relative to other state groups. In the example of the present disclosure, the combination formed by the intermediate state groups of the two memory cells is discarded, so that at least one of the two memory cells is in the rest of the state groups, so that the read noise of the state combination of the two memory cells may be reduced, and the reliability of data reading is improved.

In some examples, data corresponding to the first combination through the eighth combination is encoded by using a Gray code encoding manner.

FIG. 8 shows a correspondence between the first combination through the eighth combination and the 3 bits of data in FIG. 7 in a form of a table. As shown in FIG. 7 and FIG. 8, the data corresponding to the first combination through the eighth combination is sequentially 111, 110, 010, 011, 001, 000, 100 and 101. Since only one bit changes between adjacent codes of the Gray code, even if a single bit error occurs during data storage or transmission, it is easier to detect and correct. In this way, the reliability of data storage can be improved, and the risk of data loss can be reduced.

With continued reference to FIG. 7, the center of the nine-grid corresponds to a combination formed by the intermediate state group S1 of the first memory cell and the intermediate state group S1 of the second memory cell, and this combination is not used to store data. The first combination through the eighth combination are arranged anticlockwise along the nine-grid. In some examples, the Gray code sequence in FIG. 7 may be rotated to obtain different correspondences between the first combination through the eighth combination and the 3 bits of data. FIG. 9 shows another correspondence obtained when the Gray code sequence in the nine-grid of FIG. 7 is rotated clockwise by one step. Specifically, data corresponding to the first combination through the eighth combination is sequentially 110, 010, 011, 001, 000, 100, 101, and 111.

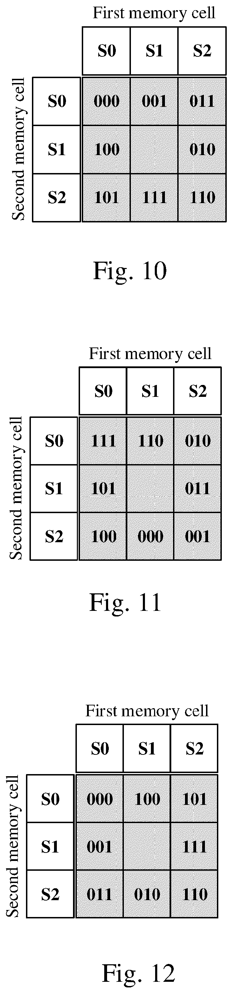

In the same manner, when the Gray code sequence in the nine-grid of FIG. 7 is rotated clockwise by two steps, data corresponding to the first combination through the eighth combination may be obtained sequentially as 010, 011, 001, 000, 100, 101, 111 and 110. When rotated by three steps, data corresponding to the first combination through the eighth combination may be obtained sequentially as 011, 001, 000, 100, 101, 111, 110 and 010. When rotated by four steps, data corresponding to the first combination through the eighth combination may be obtained sequentially as 001, 000, 100, 101, 111, 110, 010, and 011. When rotated by five steps, as shown in FIG. 10, data corresponding to the first combination through the eighth combination may be obtained sequentially as 000, 100, 101, 111, 110, 010, 011 and 001. When rotated by six steps, data corresponding to the first combination through the eighth combination may be obtained sequentially as 100, 101, 111, 110, 010, 011, 001 and 000. When rotated by seven steps, data corresponding to the first combination through the eighth combination may be obtained sequentially as 101, 111, 110, 010, 011, 001, 000 and 100.

In some examples, the Gray code sequence in FIG. 7 may also be reversed to obtain another correspondence between the first combination through the eighth combination and the 3 bits of data. FIG. 11 shows another correspondence between the first combination through the eighth combination and the 3 bits of data obtained after the Gray code sequence in the nine-grid of FIG. 7 is reversed. Specifically, the data corresponding to the first combination through the eighth combination is sequentially 111, 101, 100, 000, 001, 011, 010 and 110.

For example, the Gray code sequence in FIG. 11 may also be rotated to obtain another correspondence between the first combination through the eighth combination and the 3 bits of data. For example, when the Gray code sequence in the nine-grid of FIG. 11 is rotated clockwise by one step, data corresponding to the first combination through the eighth combination may be obtained sequentially as 101, 100, 000, 001, 011, 010, 110, and 111. When rotated by two steps, data corresponding to the first combination through the eighth combination may be obtained sequentially as 100, 000, 001, 011, 010, 110, 111 and 101. When rotated by three steps, as shown in FIG. 12, data corresponding to the first combination through the eighth combination may be obtained sequentially as 000, 001, 011, 010, 110, 111, 101 and 100. When rotated by four steps, data corresponding to the first combination through the eighth combination may be obtained sequentially as 001, 011, 010, 110, 111, 101, 100, and 000. When rotated by five steps, data corresponding to the first combination through the eighth combination may be obtained sequentially as 011, 010, 110, 111, 101, 100, 000 and 001. When rotated by six steps, data corresponding to the first combination through the eighth combination may be obtained sequentially as 010, 110, 111, 101, 100, 000, 001 and 011. When rotated by seven steps, data corresponding to the first combination through the eighth combination may be obtained sequentially as 110, 111, 101, 100, 000, 001, 011 and 010.

As shown above, the Gray code sequence in the nine-grid of FIG. 7 may be rotated and reversed to obtain 16 correspondences between the first combination through the eighth combination and the 3 bits of data, that is, 16 encoding manners may be obtained. Since none of the 16 encoding manners includes a combination formed by the respective intermediate state groups of the first memory cell and the second memory cell, any one of the 16 encoding manners may be used to reduce read noise and improve reliability of data storage. In addition, data corresponding to the first combination through the eighth combination is encoded using a Gray code encoding manner, which only causes errors of a single bit that is easily detected and corrected, thereby improving the reliability of data storage and reducing the risk of data loss.

In some examples, the state group may be represented by a state code, which may include a plurality of bits. In this example, since the number Q of state groups is 3, the state code may include two bits, for short, two-bit. The two bits have 4 possible values, that is, 11, 01, 00 and 10, respectively. Three state groups may be represented by 3 of the 4 values. For example, three state groups may be represented by 11, 01, and 00, or three state groups may be represented by 11, 10, and 00. In some examples, the S0 state group may be represented by 11, the S1 state group may be represented by 01, and the S2 state group may be represented by 00.

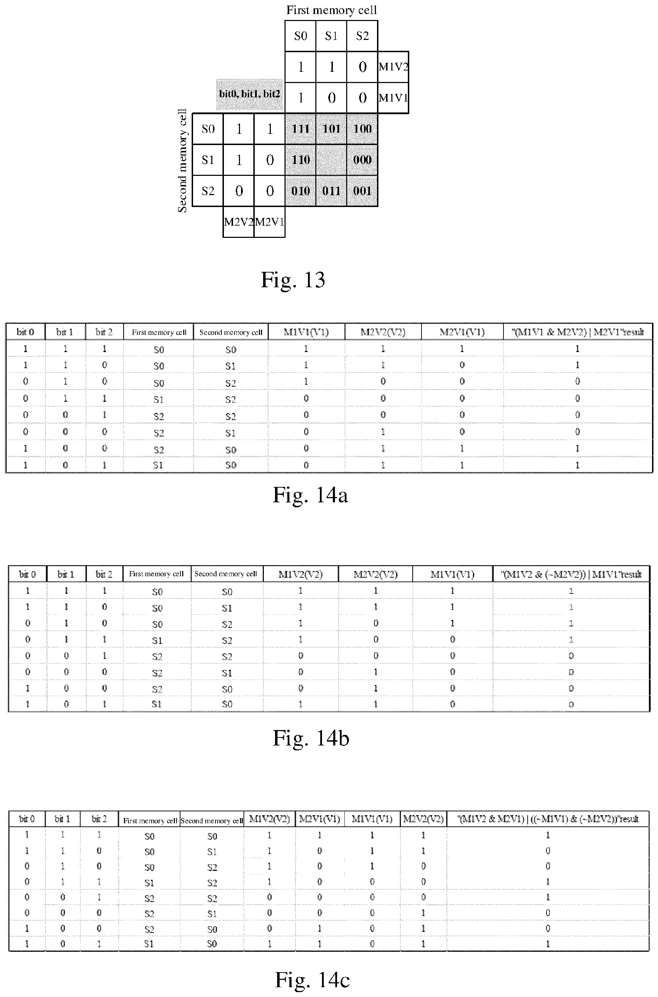

The present disclosure takes the S0 state group being represented by 11, the S1 state group being represented by 01, and the S2 state group being represented by 00 as an example to describe the manner of obtaining the 3 bits of data jointly stored by the two memory cells by using the state codes of the two memory cells. FIG. 13 shows a correspondence between 3 bits of data bit0, bit1, bit2 and state codes of two memory cells, and the encoding manner of FIG. 13 is the same as that of FIG. 7, with further showing the state codes of each state group. Taking bit0, bit1, bit2 being 110 as an example, the state code of the first memory cell is 11, and the state code of the second memory cell is 01. Then, taking bit0, bit1, bit2 being 011 as an example, the state code of the first memory cell is 01, and the state code of the second memory cell is 00. Other cases may be understood with reference to FIG. 13.

The correspondence in FIG. 13 leads to a first logic relationship between the values of bit0, bit1, bit2 and the state codes of the two memory cells as follow: $Bit 0 = \left(M1V1 & M2V2\right) \left|M2V1\right.$ $Bit 1 = \left(M1V2 & \left(∼M2V2\right)\right) \left|M1V1\right.$ $Bit 2 = \left(M1V2 & M2V1\right) \left|\left(\left(∼M1V1\right)&\left(∼M2V2\right)\right)\right.$

Herein, the state code of the first memory cell is defined as the first state code, and the state code of the second memory cell is defined as the second state code. As shown in FIG. 13, the first state code may include any of 11, 01, and 00, and the second state code may include any one of 11, 01, and 00. M1V1 represents the first bit of the first state code, and when the first memory cell is in the S0 state group, the value of the first bit of the first state code is 1. If the first memory cell is in the S1 state group or the S2 state group, the value of the first bit of the first state code is 0. M1V2 represents the second bit of the first state code, and the value of the second bit of the corresponding first state code when the first memory cell is in different state groups may be understood with reference to FIG. 13. M2V1 represents the first bit of the second state code, M2V2 represents the second bit of the second state code, and the values of the first bit and the second bit of the corresponding second state code when the second memory cell is in the different state group may be understood with reference to FIG. 13.

With reference to the above first logic relationship, the value of bit0 may be obtained by performing an AND operation on M1V1 and M2V2, and then performing an OR operation on the result of the AND operation and M2V1. FIG. 14a verifies that bit0 in each data in the nine-grid of FIG. 13 can be obtained by calculating the above logic formula. The first column to the third column in FIG. 14a show possible 8 values of 3 bits of data (bit0, bit1, bit2), the fourth column and the fifth column show the state groups of the first memory cell and the second memory cell corresponding to each value, the sixth column to the eighth column sequentially show values of M1V1, M2V2, and M2V1, and the ninth column shows the result of the logic operation of (M1V1 & M2V2) | M2V1, wherein the operation result of the ninth column is the same as the value of bit0 in the first column, which verifies that bit0 can be obtained by calculating the above logic formula.

The value of bit1 may be obtained by performing an AND operation on (~M2V2) and M1V2, and then performing an OR operation on the result of the AND operation and M1V1. FIG. 14b verifies that bit1 in each data in the nine-grid can be obtained by calculating the above logic formula. The value of bit2 may be obtained by performing an AND operation on M1V2 and M2V1, performing an AND operation on (~M1V1) and (~M2V2), and then performing an OR operation on the result of the two AND operations. FIG. 14c verifies that bit2 in each data in the nine-grid can be obtained by calculating the above logic formula.

With reference to the above first logic relationship, each of bit0, bit1, and bit2 is calculated based on two bits of one of the first state code and the second state code, and at least one bit of the other one of the first state code and the second state code. The above 16 encoding manners have equivalent logical topology structures to the encoding manners shown in FIG. 13. Therefore, when any encoding manner in the above 16 encoding manners is used, two bits of one of the first state code and the second state code, and at least one bit of the other one of the first state code and the second state code are both needed for calculating the value of each of bit0, bit1, bit2.

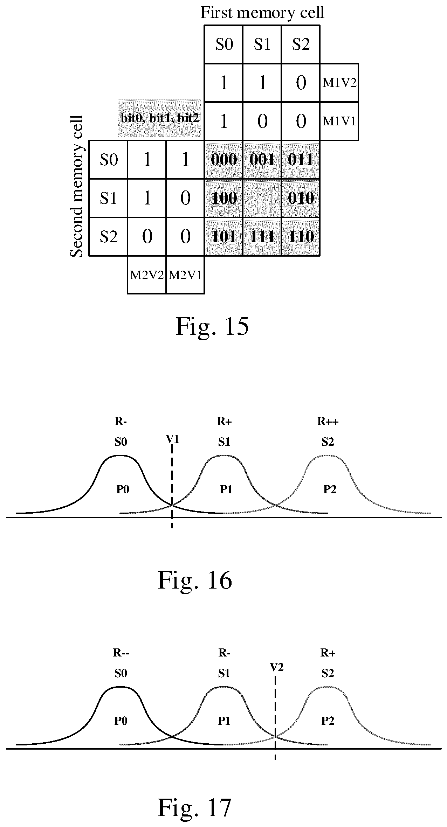

The following takes the encoding mode of FIG. 10 as an example for verification. FIG. 15 has the same encoding manner as that of FIG. 10, with only further showing the state codes of the state groups. The correspondence shown in FIG. 15 causes a second logic relationship between bit0, bit1, bit2 and the state codes of the two memory cells as follow: $Bit 0 = \left(M1V1 &\left(∼M2V1\right)\right) \left|\left(∼M2V2\right)\right.$ $Bit 1 = \left(\left(∼M1V1\right)&\left(∼M2V2\right)\right) \left|\left(∼M1V2\right)\right.$ $Bit 2 = \left(M1V2 &\left(∼M2V2\right)\right) \left|\left(\left(∼M1V1\right)& M2V1\right)\right.$

In the second logic relationship, the logic formulas for calculating bit0, bit1 and bit2 are different from the first logic relationship, but the commonality is that the value of each of bit0, bit1, and bit2 is determined by two bits of one of the first state code and the second state code, and at least one bit of the other one of the first state code and the second state code.

Each bit in the first state code of the first memory cell and the second state code of the second memory cell may be obtained in a read operation, and the values of bit0, bit1, and bit2 may be obtained by performing logic operations with reference to the above mentioned logic relationship.

FIG. 16 shows a schematic diagram of threshold voltage distribution of a memory cell storing 1.5 bits of data. From the perspective of the state code, the following illustrates that discarding the combination formed by the intermediate state groups of the two memory cells and jointly storing data using other combinations may reduce read noise with reference to FIG. 16.

When a single memory cell stores 1.5 bits of data, each state group includes one state. As shown in FIG. 16, the S0 state group includes the P0 state, the S1 state group includes the P1 state, and the S2 state group includes the P2 state. The first read voltage V1 is used to divide the S0 state group and the S1 state group, and the first read voltage V1 may be located between the threshold voltage distribution corresponding to the P0 state and the threshold voltage distribution corresponding to the P1 state. The second read voltage V2 is used to divide the S1 state group and the S2 state group, and the second read voltage V2 may be located between the threshold voltage distribution corresponding to the P1 state and the threshold voltage distribution corresponding to the P2 state.

When the first read voltage V1 is applied to the word line, since V1 is between the threshold voltage distributions of the S0 state group and the S1 state group, the probability of the first bits of the state codes of the memory cells in the S0 state group and the S1 state group being accurately read is the same, and the read results of the memory cells in the S0 state group and the S1 state group are indicated by R - and R +, respectively. Since V1 is far away from the threshold voltage distribution of the S2 state group, the probability of the first bit of the state code of the memory cell in the S2 state group being accurately read is higher, and the read result of the memory cell in the S2 state group is indicated by R + +, wherein R + + is more reliable than R +, and the reliabilities of R - and R + are the same.

Similarly, as shown in FIG. 17, when the second read voltage V2 is applied, since V2 is between the threshold voltage distributions of the S1 state group and the S2 state group, the probability of the second bits of the state codes of the memory cells in the S1 state group and the S2 state group being accurately read is the same, and the read results of the memory cells in the S1 state group and the S2 state group are indicated by R - and R +, respectively. Since V2 is far away from the threshold voltage distribution of the S0 state group, the probability of the second bit of the state code of the memory cell in the S0 state group being accurately read is higher, and the read result of the memory cell in the S0 state group is indicated by R - -, wherein R -- is more reliable than R -.

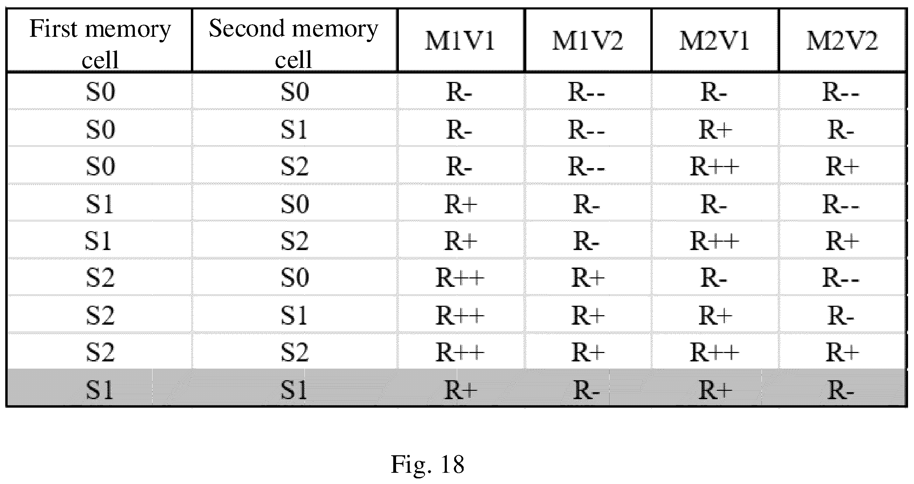

FIG. 18 lists the read results of the memory cells in each state group when the first read voltage V1 and the second read voltage V2 are applied. As shown in FIG. 18, in the combination formed by the intermediate state groups of the two memory cells, the read result of the state code is R - or R + with a lower reliability, and the other 8 combinations include the result R + + or R - - with a higher reliability. That is, the read reliability of the state code in the other 8 combinations is higher, the reliability of the values of bit0, bit1 and bit2 obtained by the logic operation is higher, so that the reliability of the read operation of the memory device is improved, which facilitates high-speed reading.

In some examples, when the number of state groups is 3, each memory cell includes 3 × 2^{K} states, and two memory cells may combine 9 × 2^{2K} state combinations. 2^{2K} state combinations formed by 2^{K} states within the intermediate state group of the first memory cell and 2^{K} states within the intermediate state group of the second memory cell are discarded, and the remaining 8 × 2^{2K} state combinations are used to store 3 + 2K bits of data.

In the 3 + 2K bits of data, as described above, the 3 bits of data is jointly stored by the state groups where the first memory cell and the second memory cell are located. For example, the K bits of data in the 2K data are separately stored by the first memory cell, and the other K bits of data are separately stored by the second memory cell.

In some examples, when the memory device receives the three bits of data of bit0, bit1, bit2, the data of bit0, bit1, bit2 may be converted into the first state code of the first memory cell and the second state code of the second memory cell. The first state may include any one of 11, 01, and 00, and the first state code may determine the first target state group to which the first memory cell is to be programmed. The second state code may include any one of 11, 01, and 00, and the second state code may determine that the second memory cell is to be programmed to the second target state group.

When the memory device continues to receive the K bits of data, it may be further determined which of the 2^{K} states the first memory cell in the first target state group is to be programmed into. That is, the first memory cell may use 2^{K} states in the state group to store the K bits of data. Likewise, when the memory device further receives the other K bits of data, it may be further determined which of the 2^{K} states the second memory cell in the second target state group is to be programmed into. That is, the second memory cell may also use 2^{K} states in the state group to store the other K bits of data.

K is an integer greater than or equal to 0, for example, may be 0, 1, 2, 3, or the like. That is, each state group may include 1 state, 2 states, 4 states, 8 states, and the like.

When each of the 3 state groups include 1 state (K = 0), each memory cell may be in one of 3 states, and 8 state combinations may be selected from the 9 state combinations formed by the two memory cells to store 3 bits of data. On average for a single memory cell, it may be understood that a single memory cell stores 1.5 bits of data.

When each state group includes 2 states (K = 1), each memory cell may be in one of 6 (3 × 2) states, and reliable 32 state combinations may be selected from 36 state combinations formed by two memory cells to store 5 bits of data, then it may be understood that single memory cell stores 2.5 bits of data. For example, two memory cells may jointly store 3 bits of data, with each of the memory cells separately storing 1 bit of data.

When each state group includes 4 states (K = 2), each memory cell may be in one of 12 (3 × 4) states, and 128 state combinations may be selected from 144 state combinations formed by two memory cells to store 7 bits of data, then it may be understood that single memory cell stores 3.5 bits of data. For example, two memory cells can jointly store 3 bits of data, with each of the memory cells separately storing 2 bits of data.

When each state group includes 8 states (K = 3), each memory cell may be in one of 24 (3 × 8) states, and 512 state combinations may be selected from 576 state combinations formed by two memory cells to store 9 bits of data, then it may be understood that single memory cell stores 4.5 bits of data. For example, two memory cells can jointly store 3 bits of data, with each of the memory cells separately storing 3 bits of data.

In summary, when the single memory cell stores the X.5 bits of data, the 1.5 bits of data is stored by jointly storing the 3 bits of data by the two memory cells, and the 3 bits of data is jointly determined by the state groups to which the two memory cells belong, wherein the two memory cells are both in the rest of the number of state groups excluding the intermediate state group, or one of the two memory cells is in the intermediate state group, and the other is in one of the rest of the number of state groups, such that the case that both memory cells are in the intermediate state group is discarded, the read noise of the 3 bits of data can be reduced, the signal quality is improved, and the probability of failed the error correction and the decoding time are reduced. And the read reliability can be improved, which facilitates high-speed reading.

The present disclosure further provides a memory device including a memory cell array and a peripheral circuit, the memory cell array includes: a plurality of memory cells, wherein each of the memory cells is in one of Q × 2^{K} states; wherein states of two memory cells coupled to a same word line form a plurality of state combinations for storing Q + 2K bits of data, and Q and K are both integers; and a peripheral circuit coupled to the memory cell array; wherein when reading each bit in the Q bits of data, the peripheral circuit is configured to:
applying a first read voltage V1 to a selected word line; and
after applying the first read voltage, applying a second read voltage V2 to the selected word line, wherein the voltage value of the first read voltage V1 is different from the second read voltage V2.

The first read voltage V1 is configured to divide adjacent first state groups and second state groups in the Q state groups, and the second read voltage V2 is configured to divide adjacent second state groups and third state groups. For example, threshold voltages of the first state group, the second state group, and the third state group are sequentially increased, or threshold voltages of the first state group, the second state group, and the third state group are sequentially decreased.

After applying the first read voltage V1 and the second read voltage V2 to the selected word line, the first target state group to which the first memory cell belongs and the second target state group to which the second memory cell belongs may be determined. The first target state group includes any one of the first state group through the third state group, and the second target state group includes any one of the first state group through the third state group. Then, the value of the to-be-read bit in the Q bits of data may be determined by using the first target state group and the second target state group in combination with the correspondence between the combination of the three state groups of the two memory cells and the Q bits of data.

The word lines may be word lines 318 shown in FIG. 3, each of which are coupled to a plurality of memory cells 306. For example, the plurality of memory cells coupled to the word line may include a first memory cell group and a second memory cell group, the number of the first memory cells in the first memory cell group is equal to the number of the second memory cells in the second memory cell group, and the i^{th} first memory cell in the first memory cell group and the i^{th} second memory cell in the second memory cell group form a pair to jointly store the Q + 2K bits of data. When the first read voltage and the second read voltage are applied to the selected word line, the state groups to which all the first memory cells and all the second memory cells belong may be read, so that the value of the to-be-read bit in the Q bits of data jointly stored by each pair of the first memory cell and the second memory cell may be determined.

In some examples, when reading each bit in the Q bits of data, the peripheral circuit is configured to:
obtain a first state code and a second state code, wherein the first state code indicates that a first memory cell of the two memory cells is in a first target state group, and the second state code indicates that the second memory cell is in a second target state group, and determine a value of a to-be-read bit in the Q bits of data based on the first state code and the second state code.

The state group may be represented by a state code that includes a plurality of bits. The first state code is a state code corresponding to a first target state group where the first memory cell is located, and the first target state code may include any one of a plurality of state codes corresponding to the plurality of state groups. The second state code is a state code corresponding to a second target state group where the second memory cell is located, and the second target state code may include any one of a plurality of state codes corresponding to the plurality of state groups. After applying the first read voltage and the second read voltage to the selected word line, the page buffer may directly obtain the first state code and the second state code. Since the state code includes bits, a logic operation may be supported, and then a logic operation may be performed based on the first state code and the second state code to determine the value of the to-be-read bit.

In the example, the state code is introduced to represent the state group. Since the state code may support a logic operation, the value of the to-be-read bit in the Q data may be calculated by using a logic circuit of hardware in the peripheral circuit. In this way, where a logic operation is performed by hardware, the operation process is simple and the reliability of the operation result is high, while the cost is increased very little.

In some examples, the number Q of state groups is 3, and the threshold voltages of the first state group, the second state group, and the third state group are sequentially increased. For example, the first state group, the second state group, and the third state group are sequentially S0 state group, S1 state group, and S2 state group. The voltage value of the first read voltage V1 is smaller than that of the second read voltage V2. The first read voltage V1 may be located between the threshold voltage distribution of the highest state in the S0 state group and the threshold voltage distribution of the lowest state in the S1 state group, and the second read voltage V2 may be located between the threshold voltage distribution of the highest state in the S1 state group and the threshold voltage distribution of the lowest state in the S2 state group.

As shown in FIG. 16, the S0 state group includes the P0 state, the S1 state group includes the P1 state, and the S1 state group includes the P2 state. The first read voltage V1 is configured to divide the S0 state group and the S1 state group, and the first read voltage V1 may be located between the threshold voltage distribution corresponding to the P0 state and the threshold voltage distribution corresponding to the P1 state. The second read voltage V2 is configured to divide the S1 state group and the S2 state group, and the second read voltage V2 may be located between the threshold voltage distribution corresponding to the P1 state and the threshold voltage distribution corresponding to the P2 state.

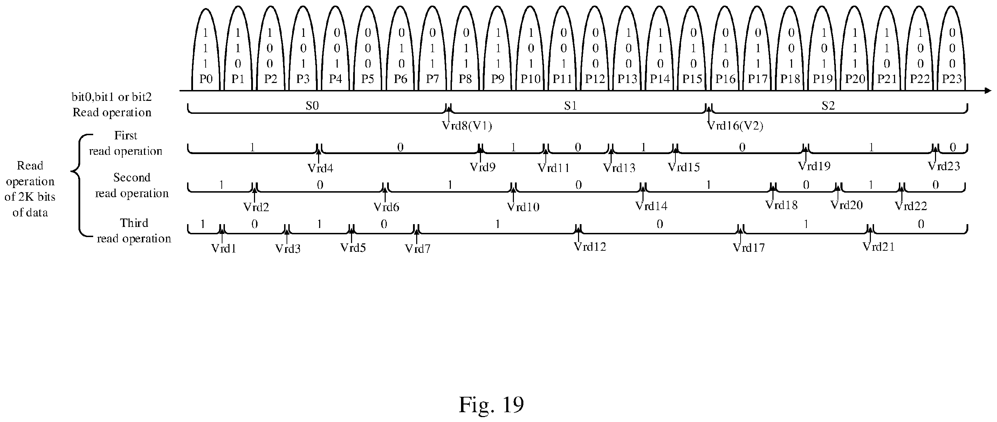

FIG. 19 shows a schematic diagram of threshold voltage distribution of a memory cell storing 4.5 bits of data. When a single memory cell stores 4.5 bits of data, each state group includes 8 states. As shown in FIG. 19, the S0 state group includes the P0 state ~ P7 state, the S1 state group includes the P8 state ~ P15 state, and the S2 state group includes the P16 state ~ P23 state. The first read voltage V1 may be located between the P7 state and the P8 state, and the second read voltage V2 may be located between the P15 state and the P16 state.

In some examples, when the number Q of state groups is 3, the state code includes two bits. For example, as shown in FIG. 13 and FIG. 15, the S0 state group is represented by a state code 11, the S1 state group is represented by a state code 01, and the S2 state group is represented by a state code 00. The peripheral circuit is configured to: after applying the first read voltage V1 to the selected word line, obtain respective first bits in the first state code and the second state code; and after applying the second read voltage V2 to the selected word line, obtain respective second bits in the first state code and the second state code.

Referring to FIG. 13 and FIG. 16, after applying the first read voltage V1 to the selected word line, since the first read voltage V1 may divide the S0 state group and the S1 state group, the value read from the memory cell of the S0 state group is 1, and the values read from the memory cells of the S1 state group and the S2 state group are 0, which are the same as the first bits of the respective state codes of the S0 state group, the S1 state group, and the S2 state group. Therefore, regardless of which state group the first memory cell and the second memory cell are located in, the first bit of the state code of the state group in which the first memory cell and the second memory cell are located may be read to obtain the respective first bits of the first state code and the second state code.

Referring to FIG. 13 and FIG. 17, after applying the second read voltage V2 to the selected word line, since the second read voltage V2 may divide the S1 state group and the S2 state group, the values read from the memory cells of the S0 state group and the S1 state group are 1, and the value read from the memory cell of the S2 state group is 0, which is the same as the respective second bits of the state codes of the S0 state group, the S1 state group, and the S2 state group. Therefore, the respective second bits of the first state code and the second state code may be obtained by applying the second read voltage V2.

In some examples, when reading each bit in the Q bits of data, the peripheral circuit is configured to:
determine a value of a to-be-read bit in the Q bits of data based on two bits of one of the first state code and the second state code, and at least one bit of the other one of the first state code and the second state code.

Referring to the logic formula of bit0, bit1, and bit2 shown in the first logic relationship and the second logic relationship, the value of any one of bit0, bit1, and bit2 may be obtained by performing a logic operation on two bits of one of the first state code and the second state code and at least one bit of the other one of the first state code and the second state code. If each bit in the first state code and the second state code is considered to be a read result, at least 3 read results are needed to determine the value of any one of bit0, bit1 and bit2. In the first logic relationship and the second logic relationship, 3 read results are needed to determine the values of bit0 and bit1, while 4 read results are needed to determine the value of bit2. When using other encoding manners in the 16 encoding manners, 4 read results may be needed to determine the value of bit0, and 3 read results are needed to determine the values of bit1 and bit2.

In some examples, the peripheral circuit is configured to:
perform a first logic operation on one bit in the first state code and two bits in the second state code to obtain a value of the first bit in the Q bits of data;
perform a second logic operation on two bits in the first state code and one bit in the second state code to obtain a value of the second bit in the Q bits of data; and
perform a third logic operation on two bits in the first state code and two bits in the second state code to obtain a value of a third bit in the Q bits of data.

Here, the first bit, the second bit, and the third bit in the Q bits of data are not corresponding to bit0, bit1 and bit2 in sequence, and are only used to identify the three bits. The first logic operation, the second logic operation, and the third logic operation may be determined based on a logic relationship between bit0, bit1, bit2 and the state codes of the two memory cells. For example, when the encoding manner of FIG. 13 is used, the three logic operations may be determined based on the above first logic relationship. For example, when the encoding manner of FIG. 15 is used, the three logic operations may be determined based on the above second logic relationship. For example, the first logic operation, the second logic operation, and the third logic operation are different from each other.

Referring to the above first logic relationship or the second logic relationship, bit0 may be obtained by performing a first logic operation on one bit in the first state code and two bits in the second state code, bit1 may be obtained by performing a second logic operation on two bits in the first state code and one bit in the second state code, and bit2 may be obtained by performing a third logic operation on two bits in the first state code and two bits in the second state code. It should be noted that the first logic operation may be different operations in different encoding manners. For example, when the encoding manner of FIG. 13 is used, the first logic operation includes an AND operation and an OR operation, when the encoding manner of FIG. 15 is used, the first logic operation includes two NOT operations, an AND operation, and an OR operation. Similarly, the second logic operation may be different operations in different encoding manners, and the third logic operation may be different operations in different encoding manners.

In some examples, the peripheral circuit is configured to:
in a first read stage, sequentially apply a first read voltage V1 and a second read voltage V2 to the selected word line;
in a second read stage, sequentially apply the first read voltage V1 and the second read voltage V2 to the selected word line; and
in a third read stage, sequentially apply the first read voltage V1 and the second read voltage V2 to the selected word line.

When Q is 3, three read stages are needed to read 3 bits of data, and the first read voltage V1 and the second read voltage V2 are applied to the selected word line at each of the read stages, and read voltages are applied 6 times in total.

In some examples, the peripheral circuit is configured to:
in a first read stage, apply a first read voltage V1 and a second read voltage V2 to the selected word line to obtain a first state code and a second state code, and perform a first logic operation on one bit in the first state code and two bits in the second state code to obtain a value of a first bit in the Q bits of data;
in a second read stage, apply the first read voltage V1 and the second read voltage V2 to the selected word line to obtain the first state code and the second state code, and perform a second logic operation on two bits in the first state code and one bit in the second state code to obtain a value of a second bit in the Q bits of data; and
in a third read stage, apply the first read voltage V1 and the second read voltage V2, and perform a third logic operation on two bits in the first state code and two bits in the second state code to obtain a value of a third bit in the Q bits of data.

The peripheral circuit may read the Q bits of data bit by bit, and when reading each bit in the Q bits of data, after applying the first read voltage V1 and the second read voltage V2 to the selected word line to obtain the first state code and the second state code, the peripheral circuit (for example, the read logic circuit 620 hereinafter) may directly perform the corresponding logic operation to obtain and output the value of the to-be-read bit instead of waiting to perform the logic operation until the read voltages of the three read stages are applied. In the present disclosure, the order of the first read stage, the second read stage and the third read stage depends on the encoding manner. When the encoding manner of FIG. 13 or FIG. 15 is used, the second read stage is after the first read stage, and the third read stage is after the second read stage.

In some examples, each of the first logic operation, the second logic operation, and the third logic operation includes an AND operation, and an OR operation.

In the two encoding manners shown in FIG. 13 and FIG. 15, each of the first logic operation, the second logic operation, and the third logic operation includes an AND operation, and an OR operation. However, other encoding manners in the 16 encoding manners have logic topology structures equivalent to the two encoding manners, so that when other encoding manners are used, each of the first logic operation, the second logic operation, and the third logic operation also includes an AND operation, and an OR operation. The first logic operation, the second logic operation, or the third logic operation may further include a NOT operation, and the positions and the number of the NOT operations may be different in different encoding manners.

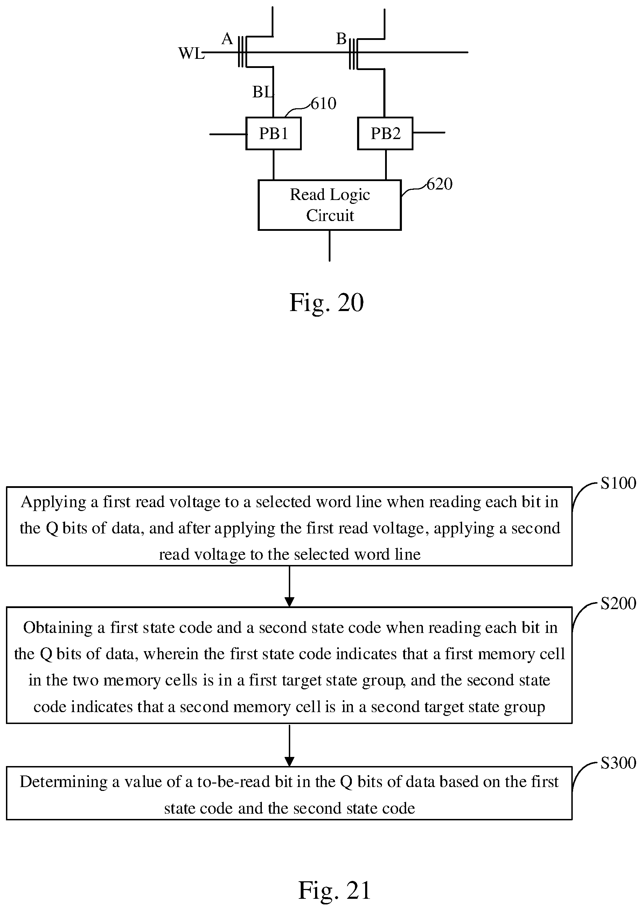

In some examples, as shown in FIG. 20, the peripheral circuit further includes a first page buffer PB1, a second page buffer PB2, and a read logic circuit 620. The first page buffer PB1 is coupled to the first memory cell A and is configured to: obtain a first state code. The second page buffer PB2 is coupled to the second memory cell B and is configured to: obtain a second state code. The read logic circuit 620 is coupled to the first page buffer PB1 and the second page buffer PB2 and is configured to: obtain the value of the to-be-read bit of the Q bits of data based on two bits of one of the first state code and the second state code, and at least one bit of the other one of the first state code and the second state code.

For example, the first page buffer PB1 and the second page buffer PB2 are two of a plurality of page buffers 610. The page buffer 610 may perform the same sensing operation as in the read operations of the single level memory cell and the multi-level memory cell to obtain the state code. In this example, the read logic circuit 620 is disposed outside the page buffer, and the read logic circuit 620 may perform the first logic operation, the second logic operation and the third logic operation to obtain the value of each bit in the Q bits of data. The setting of the read logic circuit 620 requires minimal modifications to the existing circuit, such as only adding some logic circuits while other peripheral circuit modules remain almost the same. This may reduce cycles of the design and verification and improve the reliability of the memory. For example, the page buffer 610 may be the page buffer/sense amplifier 504 in FIG. 6, and the read logic circuit 620 may be the read logic circuit 505 in FIG. 6.

In the example of the present disclosure, when reading each bit of data in the Q bits of data, a word line driver (for example, the row decoder/WL driver 508 in FIG. 6) in the peripheral circuit applies a first read voltage to the selected word line, the first page buffer obtains a first bit in the first state code, and the second page buffer obtains a first bit in the second state code. The word line driver continues to apply a second read voltage to the selected word line, the first page buffer obtains a second bit in the first state code, and the second page buffer obtains a second bit in the second state code. The first page buffer and the second page buffer may send two bits of one of the first state code and the second state code, and at least one bit of the other one of the first state code and the second state code required by the logic operation to the read logic circuit according to the logic operation corresponding to the to-be-read bit, and the read logic circuit performs a logic operation (that is, one of the first logic operation, the second logic operation, and the third logic operation) corresponding to the to-be-read bit to obtain the value of the to-be-read bit.

When such a read operation is used, the AND gate, the OR gate and the NOT gate in the read logic circuit may be time-multiplexed, so that the circuit structure and the footprint of the read logic circuit may be simplified, which facilitates miniaturization of the memory device. In addition, when obtaining the first bit in the state code, the page buffer may send the first bit to the read logic circuit, so as to reduce occupation of the latch, which facilitates the reduction of the footprint of the page buffer, thereby facilitating miniaturization of the device.

In further examples, it may be that when reading the Q bits of data, first read voltage and second read voltage are applied only one time to the selected word line to obtain the first state code and the second state code. When such a read operation is used, the read logic circuit may include a first logic operation circuit, a second logic operation circuit, and a third logic operation circuit, and the first logic operation circuit, the second logic operation circuit, and the third logic operation circuit use the first state code and the second state code to perform a logic operation at the same time. Alternatively, the read logic circuit may also sequentially calculate each bit in the Q bits of data, and time-multiplex the AND gate, the OR gate and the NOT gate, where more latches may be needed in the page buffer to latch the state code. Such a read operation needs more hardware circuit support, which is not conducive to miniaturization of the memory device.

In some examples, the read logic circuit 620 at least includes a first AND gate, a second AND gate, and an OR gate, wherein the first input terminal and the second input terminal of the first AND gate are respectively coupled to the first page buffer and the second page buffer, the first input terminal and the second input terminal of the second AND gate are respectively coupled to the first page buffer and the second page buffer, and the first input terminal and the second input terminal of the OR gate are respectively coupled to the output terminal of the first AND gate and the output terminal of the second AND gate, and the output terminal of the OR gate outputs the value of the to-be-read bit in the Q bits of data.

The first AND gate, the second AND gate, and the OR gate are configured to implement an AND operation and an OR operation in the first logic operation, the second logic operation, and the third logic operation. It should be understood that the read logic circuit 620 may also include a NOT gate. In an example in which different encoding manners are used, the positions and number of the NOT gates may be set according to, for example, the logical formula for calculating bit0, bit1 and bit2 shown in the first logic relationship or the second logic relationship. The read logic circuit 620 may further include a selector that selects different input signals for the first AND gate, the second AND gate, and the OR gate that are time-multiplexed when calculating bit0, bit1, and bit2.

In some examples, the variation curve of FBC over Eb/N0 may be used to evaluate the effect of different encoding manners. For example, the variation curve of FBC over Eb/N0 under different encoding manners may be obtained by simulation. Eb/N0 represents a ratio of energy (Eb) of each bit to noise power spectral density (N0) for evaluating reliability of signal storage or transmission. The larger the ratio of Eb/N0, the higher the reliability of signal storage or transmission. FBC (Fail Bit Count) refers to a proportion of a number of erroneous bits to a total number of bits. A smaller FBC indicates a higher accuracy of reading and a better quality of data storage or transmission.

For example, the variation curve 1 and the variation curve 2 of the FBC over Eb/N0 when the single memory cell stores the 1.5 bits of data may be obtained, where the example corresponding to the curve 1 uses the encoding manner proposed in the present disclosure in which the combination formed by the intermediate state groups of the two memory cells is discarded, and the remaining 8 combinations are used to store 3 bits of data. The example corresponding to curve 2 is an existing encoding manner in which a combination formed by the intermediate states of two memory cells is used to store data. Simulation data indicates that when Eb/N0 is decreased from 5.5 to 3.0, the encoding manners of the present disclosure may have lower FBC. Especially when Eb/N0 is small, that is, when the signal quality is poor, the FBC obtained by using the encoding manners of the present disclosure is far less than the FBC obtained by using the existing encoding manners.

In a specific comparative experiment, it was experimentally verified that using a combination formed by the intermediate state groups of two memory cells to store data in existing encoding manners, the numbers of FBC when reading bit0, bit1, and bit2 are sequentially 770, 1261, and 1062. While using the encoding manner provided in FIG. 7 to store data, the numbers of FBC when reading bit0, bit1 and bit2 are sequentially 520, 745 and 1004. Compared to existing encoding manner, FBC is smaller, indicating lower noise during read operations, higher read reliability, and better quality of data storage or transmission.

In some examples, the variation curve of CWER over Eb/N0 may also be used to evaluate the effect of different encoding manners. For example, a variation curve of CWER over Eb/N0 may be obtained by simulation. CWER (frame error rate) refers to a proportion of codewords that cannot be corrected by an error correction algorithm to a total codewords during storage or transmission. The smaller the value of CWER, the smaller the read noise, the higher the quality of data storage or transmission. For example, the variation curve 1 and the variation curve 2 of the CWER over Eb/N0 when the single memory cell stores the 1.5 bits of data may be obtained, where the example corresponding to the curve 1 uses the encoding manner proposed in the present disclosure in which the combination formed by the intermediate state groups of the two memory cells is discarded, and the remaining 8 combinations are used to store 3 bits of data. The example corresponding to curve 2 is an existing encoding manner in which a combination formed by the intermediate state groups of two memory cells is used to store data. Simulation data indicates that when Eb/N0 is decreased from 5.5 to 3.5, the encoding manner according to the example of the present disclosure has a lower frame error rate compared with the existing encoding manner. Moreover, with the existing encoding manner, when Eb/N0 decreases, it is easier for the frame error rate to climb. For example, the frame error rate starts to climb when Eb/N0 decreases to 4.5 and reaches the maximum when Eb/N0 is 4.1. However, with the encoding manner according to the example of the present disclosure, when Eb/N0 decreases, it is possible for the frame error rate to delay climbing. For example, the frame error rate starts to climb when Eb/N0 decreases to 4.1 and reaches the maximum when Eb/N0 is 3.7. It can be seen that with the encoding manner according to the example of the present disclosure, the noise of the read operation may be smaller, and the quality of data storage or transmission is higher, which facilitates high-speed read operation.

The soft decision information refers to additional probability information about the state of the memory cell obtained during the reading process, and the soft decision information provides reliability information about each bit, which can be used to evaluate the reliability of reading each bit. Experiments prove that the quality of the soft decision is better when using the encoding manner according to the example of the present disclosure.

In some examples, when the encoding manner shown in FIG. 13 is used, using the memory cell with better quality as the second memory cell may result in higher quality of the data storage. For example, an RBER (raw bit error rate) may be used to evaluate the quality of the memory cell. The RBER refers to the bit error rate before the error correction process, and the bit error rate refers to the ratio of the number of erroneous bits to the total number of bits in storage or transmission. The smaller the RBER, the better the quality of the memory cell. In the example of the present disclosure, the memory cell with the small RBER value may be specified as the second memory cell, that is, the RBER value of the second memory cell is less than that of the first memory cell, thereby obtaining better quality of data storage and transmission.

In a specific comparative experiment, it was experimentally verified that when the RBER value of the second memory cell is less than that of the first memory cell, the number of FBC when reading the bit2 is 1004. After the first memory cell and the second memory cell are swapped, the number of FBC when reading the bit2 is 1119, indicating that the RBER value of the second memory cell is small, and the quality of the data storage or transmission is better.

In some examples, the peripheral circuit is configured to: apply at least Q × 2^{K} - Q read voltages to the selected word line to read the 2K bits of data.

Taking the number Q of state groups being 3 and each of the state groups including 8 states as an example to illustrate the read operation of reading the 2K bits of data. Referring to FIG. 19, each memory cell includes 24 states, which needs at least 23 read voltages. In the 23 read voltages, minus the first read voltage V1 and the second read voltage V2 located between adjacent state groups, at least 21 read voltages need to be applied to the selected word line to read the 2K bits of data.

In some examples, K bits of data stored in the first memory cell and the other K bits of data stored in the second memory cell may be read synchronously. For example, the k^{th} bit in the K bits of data stored in the first memory cell and the k^{th} bit in the other K bits of data stored in the second memory cell may be read simultaneously, wherein k is any number from 1 to K.

The following describes an example. As shown in FIG. 19, in the S0 state group, the states P0 to P7 sequentially corresponds to 111, 110, 100, 101, 001, 000, 010 and 011. In the S1 state group, the states P8 to P15 sequentially corresponds to 011, 111, 101, 001, 000, 100, 110 and 010. In the S2 state group, the states P16 to P23 sequentially corresponds to 010, 011, 001, 101, 111, 110, 100 and 000.

For example, in the first read operation of the 2K bits of data, 7 read voltages are applied to the selected word line, which are sequentially Vrd4, Vrd9, Vrd11, Vrd13, Vrd15, Vrd19 and Vrd23, to read the value of the first bit in the K bits of data stored in the first memory cell and the value of the first bit in the other K bits of data stored in the second memory cell;
In the second read operation, 7 read voltages are applied to the selected word line, which are sequentially Vrd2, Vrd6, Vrd10, Vrd14, Vrd18, Vrd20, and Vrd22, to read the value of the second bit in the K bits of data stored in the first memory cell and the value of the second bit in the other K bits of data stored in the second memory cell;
In the third read operation, 7 read voltages are applied to the selected word line, which are sequentially Vrd1, Vrd3, Vrd5, Vrd7, Vrd12, Vrd17 and Vrd21, to read the value of the third bit in the K bits of data stored in the first memory cell and the value of the third bit in the other K bits of data stored in the second memory cell.

It should be noted that the example in which the 21 read voltages are applied is not limited thereto. In different examples, the order in which the read voltages are applied may be adjusted according to the encoding manner of the 8 states in each state group.

In summary, in the present disclosure, if the first AND gate, the second AND gate and the OR gate are multiplexed, the page buffer of each memory cell performs a total of 6 (i.e., 2 + 2 + 2) sense operations to obtain the data of bit0, bit1, bit2, and if the first AND gate, the second AND gate and the OR gate are not multiplexed, the page buffer of each memory cell performs 2 sense operations to obtain bit0, bit1, bit2 data, and performs a total of 21 (i.e., 7 + 7 + 7) sense operations to obtain 3 bits of data that is stored separately, that is, the page buffer of each memory cell may perform 27 or 23 sense operations to read the 9 bits of data stored jointly in the two memory cells.

An example of the present disclosure further provides a memory system, including a memory device and a memory controller, wherein the memory device may be the memory device according to any one of the above examples. The memory controller is coupled to the memory device and is configured to control the memory device to perform operations. For example, the memory system may be the memory system shown in any one of FIGS. 1 to 2b.

The example of the present disclosure provides an operating method of a memory device, the memory device includes a memory cell array, the memory cell array includes a plurality of memory cells, and each memory cell is in one of Q * 2^{K} states, wherein states of two memory cells coupled to a same word line form a plurality of state combinations for storing Q + 2K bits of data, and Q and K are both integers. FIG. 21 is a schematic diagram of an operating method of a memory device according to an example of the present disclosure.

S100: applying a first read voltage to a selected word line when reading each bit in the Q bits of data, and after applying the first read voltage, applying a second read voltage to the selected word line.

In some examples, the operating method further comprises:
S200: obtaining a first state code and a second state code when reading each bit in the Q bits of data, wherein the first state code indicates that a first memory cell of the two memory cells is in a first target state group, and the second state code indicates that the second memory cell is in a second target state group;
S300: determining a value of a to-be-read bit in the Q bits of data based on the first state code and the second state code.

In some examples, Q is 3, and the first state code and the second state code are represented by two bits;
In step S200, obtaining the first state code and the second state code comprises:
after applying the first read voltage to the selected word line, obtaining respective first bits in the first state code and the second state code; and
after applying the second read voltage to the selected word line, obtaining respective second bits in the first state code and the second state code.

In some examples, in step S300, determining the value of the to-be-read bit in the Q bits of data based on the first state code and the second state code comprises: determining the value of the to-be-read bit in the Q bits of data based on two bits of one of the first state code and the second state code and the at least one bit of the other one of the first state code and the second state code.

In some examples, determining the value of the to-be-read bit in the Q bits of data based on two bits of one of the first state code and the second state code and the at least one bit of the other one of the first state code and the second state code comprises:
if the to-be-read bit is the first bit in the Q bits of data, performing a first logic operation on one bit in the first state code and two bits in the second state code to obtain a value of the first bit in the Q bits of data.
if the to-be-read bit is the second bit in the Q bits of data, performing a second logic operation on two bits in the first state code and one bit in the second state code to obtain a value of the second bit in the Q bits of data; and
if the to-be-read bit is the third bit in the Q bits of data, performing a third logic operation on two bits in the first state code and two bits in the second state code to obtain a value of the third bit in the Q bits of data.

In some examples, each of the first logic operation, the second logic operation, and the third logic operation includes an AND operation, and an OR operation.

In some examples, the method further comprises: applying at least Q × 2^{K} - Q read voltages to the selected word line to read the 2K bits of data.

In the operating method of the memory device according to the example of the present disclosure, when reading each bit in the Q bit data, the first read voltage and the second read voltage are applied to the selected word line, so that each bit in the Q bits of data is read bit by bit. The logic gate circuit in the read logic circuit may be time-multiplexed, so that the footprint of the read logic circuit may be reduced, which facilitates the miniaturization of the memory device.

The features disclosed in the several device examples according to the present disclosure may be arbitrarily combined without conflict to obtain a new device example.

The method disclosed in the several method examples according to the present disclosure may be arbitrarily combined without conflict to obtain a new method example.

The above descriptions are just specific examples of the present disclosure, while the scope of the present disclosure is not limited thereto, and variants or alternatives that may be easily conceived by any person skilled in the art within the scope of the present disclosure should be covered by the scope of the present disclosure.

## Claims

1. A memory device, comprising:
a memory cell array comprising a plurality of memory cells, wherein each of the memory cells is in one of Q × 2^{K} states, Q is a number of state groups, and each of the state groups comprises 2^{K} states; and
wherein a plurality of state combinations formed by states of two memory cells are configured to store a plurality of bits of data, and wherein one of the two memory cells is in an intermediate state group in the Q state groups, and the other one of the two memory cells is in one of the rest of the number of state groups excluding the intermediate state group, or the two memory cells are both in the rest of the number of state groups, the rest of the number of state groups are located on two sides of the intermediate state group, and Q and K are both integers.

2. The memory device of claim 1, wherein Q is 3; and
excluding a state combination formed by a state in the intermediate state group of the first memory cell and a state in the intermediate state group of the second memory cell in the two memory cells, the other 8 × 2^{2K} state combinations are to store 3 + 2K bits of data.

3. The memory device of claim 2, wherein in the 3 + 2K bits of data, 3 bits of data is jointly stored by a combination formed by a state group in which the first memory cell is located and a state group in which the second memory cell is located.

4. The memory device of claim 3, wherein the 3 state groups are sorted in ascending order of threshold voltages into a low state group, an intermediate state group and a high state group, and the state groups in which the first memory cell and the second memory cell are respectively located form 8 combinations, comprising:
a first combination comprising that the first memory cell is in the low state group and the second memory cell is in the low state group;
a second combination comprising that the first memory cell is in the low state group and the second memory cell is in the intermediate state group;
a third combination comprising that the first memory cell is in the low state group and the second memory cell is in the high state group;
a fourth combination comprising that the first memory cell is in the intermediate state group and the second memory cell is in the high state group;
a fifth combination comprising that the first memory cell is in the high state group and the second memory cell is in the high state group;
a sixth combination comprising that the first memory cell is in the high state group and the second memory cell is in the intermediate state group;
a seventh combination comprising that the first memory cell is in the high state group and the second memory cell is in the low state group; and
an eighth combination comprising that the first memory cell is in the intermediate state group and the second memory cell is in the low state group;
wherein data corresponding to the first combination through the eighth combination is encoded by using a Gray code encoding manner.

5. The memory device of claim 4, wherein a correspondence between the first combination through the eighth combination and the 3 bits of data comprises any one of the following:
the data corresponding to the first combination through the eighth combination is sequentially 111, 110, 010, 011, 001, 000, 100 and 101;
the data corresponding to the first combination through the eighth combination is sequentially 110, 010, 011, 001, 000, 100, 101 and 111;
the data corresponding to the first combination through the eighth combination is sequentially 010, 011, 001, 000, 100, 101, 111 and 110;
the data corresponding to the first combination through the eighth combination is sequentially 011, 001, 000, 100, 101, 111, 110 and 010;
the data corresponding to the first combination through the eighth combination is sequentially 001, 000, 100, 101, 111, 110, 010 and 011;
the data corresponding to the first combination through the eighth combination is sequentially 000, 100, 101, 111, 110, 010, 011 and 001;
the data corresponding to the first combination through the eighth combination is sequentially 100, 101, 111, 110, 010, 011, 001 and 000;
the data corresponding to the first combination through the eighth combination is sequentially 101, 111, 110, 010, 011, 001, 000 and 100;
the data corresponding to the first combination through the eighth combination is sequentially 111, 101, 100, 000, 001, 011, 010 and 110;
the data corresponding to the first combination through the eighth combination is sequentially 101, 100, 000, 001, 011, 010, 110 and 111;
the data corresponding to the first combination through the eighth combination is sequentially 100, 000, 001, 011, 010, 110, 111 and 101;
the data corresponding to the first combination through the eighth combination is sequentially 000, 001, 011, 010, 110, 111, 101 and 100;
the data corresponding to the first combination through the eighth combination is sequentially 001, 011, 010, 110, 111, 101, 100 and 000;
the data corresponding to the first combination through the eighth combination is sequentially 011, 010, 110, 111, 101, 100, 000 and 001;
the data corresponding to the first combination through the eighth combination is sequentially 010, 110, 111, 101, 100, 000, 001 and 011; and
the data corresponding to the first combination through the eighth combination is sequentially 110, 111, 101, 100, 000, 001, 011 and 010.

6. The memory device of claim 2, wherein K is 3; and
the first memory cell stores 3 bits of data in 2 × 3 bits of data separately, and the second memory cell stores the other 3 bits of data separately.

7. A memory device, comprising:
a memory cell array comprising a plurality of memory cells, wherein each of the memory cells is in one of Q × 2^{K} states, wherein states of two memory cells coupled to a same word line form a plurality of state combinations for storing Q + 2K bits of data, and Q and K are both integers; and
a peripheral circuit coupled to the memory cell array, wherein when reading each bit in Q bits of data, the peripheral circuit is configured to:
applying a first read voltage to a selected word line; and
after applying the first read voltage, applying a second read voltage to the selected word line.

8. The memory device of claim 7, wherein when reading each bit in the Q bits of data, the peripheral circuit is configured to:
obtain a first state code and a second state code, wherein the first state code indicates that a first memory cell of the two memory cells is in a first target state group, and the second state code indicates that a second memory cell is in a second target state group; and
determine a value of a to-be-read bit in the Q bits of data based on the first state code and the second state code.

9. The memory device of claim 8, wherein Q is 3, and the first state code and the second state code are represented by two bits;
the peripheral circuit is configured to:
after applying the first read voltage to the selected word line, obtain respective first bits in the first state code and the second state code; and
after applying the second read voltage to the selected word line, obtain respective second bits in the first state code and the second state code.

10. The memory device of claim 8, wherein when reading each bit in the Q bits of data, the peripheral circuit is configured to:
determine the value of the to-be-read bit in the Q bits of data based on two bits of one of the first state code and the second state code and at least one bit of the other one of the first state code and the second state code.

11. The memory device of claim 10, wherein the peripheral circuit is configured to:
perform a first logic operation on one bit in the first state code and two bits in the second state code to obtain a value of a first bit in the Q bits of data;
perform second logic operation on two bits in the first state code and one bit in the second state code to obtain a value of a second bit in the Q bits of data; and
perform a third logic operation on two bits in the first state code and two bits in the second state code to obtain a value of a third bit in the Q bits of data.

12. The memory device of claim 11, wherein the peripheral circuit is configured to:
in a first read stage, sequentially apply the first read voltage and the second read voltage to the selected word line to obtain the first state code and the second state code, and perform the first logic operation on one bit in the first state code and two bits in the second state code to obtain the value of the first bit in the Q bits of data;
in a second read stage, sequentially apply the first read voltage and the second read voltage to the selected word line to obtain the first state code and the second state code, and perform the second logic operation on two bits in the first state code and one bit in the second state code to obtain the value of the second bit in the Q bits of data; and
in a third read stage, sequentially apply the first read voltage and the second read voltage to the selected word line to obtain the first state code and the second state code, and perform the third logic operation on two bits in the first state code and two bits in the second state code to obtain the value of the third bit in the Q bits of data.

13. The memory device of claim 11, wherein each of the first logic operation, the second logic operation, and the third logic operation comprises an AND operation and an OR operation.

14. The memory device of any one of claims 8 to 13, wherein the peripheral circuit comprises:
a first page buffer coupled to the first memory cell and configured to obtain the first state code;
a second page buffer coupled to the second memory cell and configured to obtain the second state code; and
a read logic circuit coupled to the first page buffer and the second page buffer and configured to determine the value of the to-be-read bit in the Q bits of data based on the first state code and the second state code.

15. The memory device of claim 14, wherein the read logic circuit comprises at least:
a first AND gate, wherein a first input terminal and a second input terminal of the first AND gate are respectively coupled to the first page buffer and the second page buffer;
a second AND gate, wherein a first input terminal and a second input terminal of the second AND gate are respectively coupled to the first page buffer and the second page buffer; and
an OR gate, wherein a first input terminal and a second input terminal of the OR gate are respectively coupled to an output terminal of the first AND gate and an output terminal of the second AND gate, and an output terminal of the OR gate outputs the value of the to-be-read bit in the Q bits of data.

16. The memory device of claim 7, wherein the peripheral circuit is configured to:
apply at least Q × 2^{K} - Q read voltages to the selected word line to read 2K bits of data, wherein any one of the Q × 2^{K} - Q read voltages is different from the first read voltage and the second read voltage.

17. A memory system, comprising:
at least one memory device, comprising:
a memory cell array comprising a plurality of memory cells, wherein each of the memory cells is in one of Q × 2^{K} states, Q is a number of state groups, and each of the state groups comprises 2^{K} states; and
wherein a plurality of state combinations formed by states of two memory cells are configured to store a plurality of bits of data, and wherein one of the two memory cells is in an intermediate state group in the Q state groups, and the other one of the two memory cells is in one of the rest of the number of state groups excluding the intermediate state group, or the two memory cells are both in the rest of the number of state groups, the rest of the number of state groups are located on two sides of the intermediate state group, and Q and K are both integers; and
a memory controller coupled to the memory device and configured to control the memory device to perform operations.

18. An operating method of a memory device, wherein the memory device comprises a memory cell array comprising a plurality of memory cells, wherein each of the memory cells is in one of Q × 2^{K} states, wherein states of two memory cells coupled to a same word line form a plurality of state combinations for storing Q + 2K bits of data, and Q and K are both integers; and
the operating method comprises:
applying a first read voltage to a selected word line when reading each bit in Q bits of data; and
after applying the first read voltage, applying a second read voltage to the selected word line.

19. The operating method of the memory device of claim 18, further comprising:
obtaining a first state code and a second state code when reading each bit in the Q bits of data, wherein the first state code indicates that a first memory cell of the two memory cells is in a first target state group, and the second state code indicates that a second memory cell is in a second target state group; and
determining a value of a to-be-read bit in the Q bits of data based on the first state code and the second state code.

20. The operating method of the memory device of claim 19, wherein Q is 3, and the first state code and the second state code are represented by two bits;
obtaining the first state code and the second state code comprises:
after applying the first read voltage to the selected word line, obtaining respective first bits in the first state code and the second state code; and
after applying the second read voltage to the selected word line, obtaining respective second bits in the first state code and the second state code.

21. The operating method of the memory device of claim 19, wherein determining the value of the to-be-read bit in the Q bits of data based on the first state code and the second state code comprises:
determining the value of the to-be-read bit in the Q bits of data based on two bits of one of the first state code and the second state code and at least one bit of the other one of the first state code and the second state code.

22. The operating method of the memory device of claim 21, wherein applying the first read voltage to the selected word line when reading each bit in the Q bits of data, and after applying the first read voltage, applying the second read voltage to the selected word line, comprises:
in a first read stage, sequentially applying the first read voltage and the second read voltage to the selected word line;
in a second read stage, sequentially applying the first read voltage and the second read voltage to the selected word line; and
in a third read stage, sequentially applying the first read voltage and the second read voltage to the selected word line.

23. The operating method of the memory device of claim 22, wherein determining the value of the to-be-read bit in the Q bits of data based on two bits of one of the first state code and the second state code and at least one bit of the other one of the first state code and the second state code comprises:
in the first read stage, performing a first logic operation on one bit in the first state code and two bits in the second state code to obtain a value of a first bit in the Q bits of data;
in the second read stage, performing a second logic operation on two bits in the first state code and one bit in the second state code to obtain a value of a second bit in the Q bits of data; and
in the third read stage, performing a third logic operation on two bits in the first state code and two bits in the second state code to obtain a value of a third bit in the Q bits of data.

24. The operating method of the memory device of claim 23, wherein each of the first logic operation, the second logic operation and the third logic operation comprises an AND operation and an OR operation.

25. The operating method of the memory device of claim 18, further comprising:
applying at least Q × 2^{K} - Q read voltages to the selected word line to read 2K bits of data, wherein any one of the Q × 2^{K} - Q read voltages is different from the first read voltage and the second read voltage.
